## Europäisches Patentamt

## European Patent Office

## Office européen des brevets

(19)

(11) Numéro de publication: **0 096 611**
**B1**

(12)

# FASCICULE DE BREVET EUROPEEN

(45) Date de publication du fascicule du brevet:
**07.01.88**

(51) Int. Cl.⁴: **H 03 H 9/17**

(21) Numéro de dépôt: **83401025.8**

(22) Date de dépôt: **24.05.83**

(54) Résonateur piezo-électrique à haute fréquence et son procédé de fabrication.

(30) Priorité: **01.06.82 FR 8209511**

(43) Date de publication de la demande:
**21.12.83 Bulletin 83/51**

(45) Mention de la délivrance du brevet:
**07.01.88 Bulletin 88/1**

(84) Etats contractants désignés:
**BE CH DE GB IT LI NL SE**

(56) Documents cités:
**FR - A - 2 484 734**
**US - A - 3 694 677**

**L'ONDE ELECTRIQUE, vol. 59, no. 11, novembre 1979, pages 75-80, Paris, FR; M.BERTE et al.: "Résonateurs piézoélectriques à ondes de volume fonctionnant à des fréquences fondamentales supérieures à 100 MHz"**

(73) Titulaire: **COMPAGNIE D'ELECTRONIQUE ET DE PIEZO-ELECTRICITE - C.E.P.E., 44, rue de la Glacière, F-95100 Argenteuil (FR)**

(72) Inventeur: **Berte, Marc, THOMSON-CSF SCPI 173, bld Haussmann, F-75379 Paris Cedex 08 (FR)**
Inventeur: **Bidard, Louis, THOMSON-CSF SCPI 173, bld Haussmann, F-75379 Paris Cedex 08 (FR)**
Inventeur: **Lechopier, Serge, THOMSON-CSF SCPI 173, bld Haussmann, F-75379 Paris Cedex 08 (FR)**

(74) Mandataire: **Jacquard, Philippe et al, THOMSON-CSF SCPI 173, Bld Haussmann, F-75379 Paris Cedex 08 (FR)**

Il est rappelé que: Dans un délai de neuf mois à compter de la date de publication de la mention de la délivrance du brevet européen toute personne peut faire opposition au brevet européen délivré, auprès de l'Office européen des brevets. L'opposition doit être formée par écrit et motivée. Elle n'est réputée formée qu'après paiement de la taxe d'opposition (Art. 99(1) Convention sur le brevet européen).

## Description

La présente invention a pour objet un résonateur piézoélectrique à haute fréquence, en particulier un filtre, et son procédé de fabrication.

On connaît du brevet US-A-3 694 677 un résonateur piézoélectrique comprenant un disque de quartz présentant en son centre une région amincie formant une membrane, cette région amincie étant raccordée à la région non amincie par une zone formant gradin. Une électrode s'étend depuis l'extérieur du disque jusqu'au centre de la région amincie, en franchissant la région formant gradin. Sur l'autre face du disque, est disposée une autre électrode s'étendant également depuis la périphérie du disque jusqu'au centre de la région amincie. Cette autre face peut être plane ou bien présenter, également une zone formant gradin, que doit franchir l'électrode.

On constate en pratique que la réalisation des électrodes par pulvérisation ou évaporation d'une couche de métal ne donne pas satisfaction. En effet, la réalisation de ces électrodes doit répondre à plusieurs impératifs. D'une part, les électrodes doivent présenter une résistance électrique aussi faible que possible et résister aux vibrations auxquelles est soumis le cristal. D'autre part, ces électrodes ne doivent pas présenter une masse trop importante afin de ne pas provoquer de modifications importantes de la fréquence du cristal.

En pratique, les électrodes utilisées sont en argent, ou de préférence en aluminium, matériau relativement léger et de bonne conductibilité électrique. Leur épaisseur est de l'ordre de 1000 Angstroems environ, ce qui permet d'obtenir un résonateur présentant un coefficient de surtension, élevé.

Si on réalise les électrodes selon le procédé enseigné par le brevet US-A-3 694 677, on constate que celles-ci présentent un point de fragilité au niveau du gradin, c'est-à-dire qu'au bout d'un certain temps d'utilisation, et parfois même immédiatement après le traitement de vieillissement habituellement pratiqué pour stabiliser le résonateur, celui-ci se trouve hors d'usage par interruption de la continuité électrique.

La fabrication d'un résonateur piézo-électrique fiable nécessite donc de modifier la fabrication des électrodes afin d'assurer à celles-ci une bonne tenue dans le temps.

D'autre part, la Demanderesse a constaté que toute accumulation d'un matériau au niveau de la zone formant gradin, induit des contraintes dans la région amincie du cristal. Ces contraintes détériorent la dérive thermique du cristal.

La présente invention a pour objet un résonateur haute fréquence présentant des électrodes' fiables dans le temps, sans toutefois que les propriétés du résonateur soient affectées.

L'invention concerne ainsi un résonateur piézoélectrique à haute fréquence, du type comprenant une plaque ou un disque de quartz (ou autre matériau piézo-électrique) dont une région non amincie entoure une région amincie formant une membrane, la région amincie étant raccordée à la région non amincie par au moins une zone formant gradin, et comportant au moins une électrode s'étendant en franchissant le gradin depuis la région non amincie jusqu'à la région amincie, caractérisé en ce que ladite électrode est associée à une patte conductrice constituée par une couche métallique déposée dans la zone formant gradin.

Ladite couche métallique est de préférence une couche déposée par pulvérisation ou évaporation sous vide.

La patte conductrice peut être disposée endessous de l'électrode et elle peut être en or.

La patte peut avoir une épaisseur moyenne de l'ordre de 1000 Angstroems.

Une électrode peut être en argent.

Une électrode peut avoir une épaisseur comprise entre 0,05 et 0,1 μm (500 et 1000 Angstroems).

La patte conductrice peut être plus large que l'électrode.

La patte conductrice peut s'étendre depuis la région non amincie jusqu'à la partie de la région amincie jouxtant la zone formant gradin.

L'invention concerne également un résonateur constitué de deux résonateurs élémentaires couplés entre eux de manière à former un filtre.

L'invention concerne enfin un procédé de fabrication d'un tel résonateur, comportant une étape préliminaire de réalisation par usinage ionique d'une région amincie dans la partie centrale d'une plaque ou d'un disque de quartz, la région amincie étant séparée de la région non amincie par une zone formant gradin. Il est caractérisé en ce qu'il comporte les étapes suivantes:

a) une étape de dépôt d'une patte conductrice traversant la zone formant gradin;

b) une étape de montage de la plaque ou du disque sur au moins deux mâts conducteurs à l'aide d'un ciment conducteur;

c) une étape de dépôt des électrodes dont une recouvre au moins partiellement la patte conductrice, la pulvérisation étant réalisée de telle sorte que chacun des mats se trouve en contact avec une électrode.

Selon un mode de réalisation préféré, le procédé comporte une opération de mesure de la fréquence du résonateur pendant le dépôt des électrodes de manière à arrêter celui-ci lorsque la valeur désirée de la fréquence a été atteinte.

L'invention sera mieux comprise à la lecture de la description qui va suivre, donnée à titre d'exemple non limitatif, en se reportant aux des. sins ci-annexés:

— les figures 1 et 2 représentent un résonateur selon l'invention, respectivement en coupe verticale et en vue de dessus;

— la figure 3 représente un dispositif de masquage permettant de réaliser des pattes conductrices selon l'invention;

— les figures 4 et 5 illustrent les opérations de dépôt mises en œuvre pour la réalisation des pattes conductrices selon l'invention;

— les figures 6a et 6b représentent deux coupes verticales orthogonales l'une par rapport à l'autre d'un résonateur selon l'invention, dont les électrodes sont disposées de manière à réaliser un filtre.

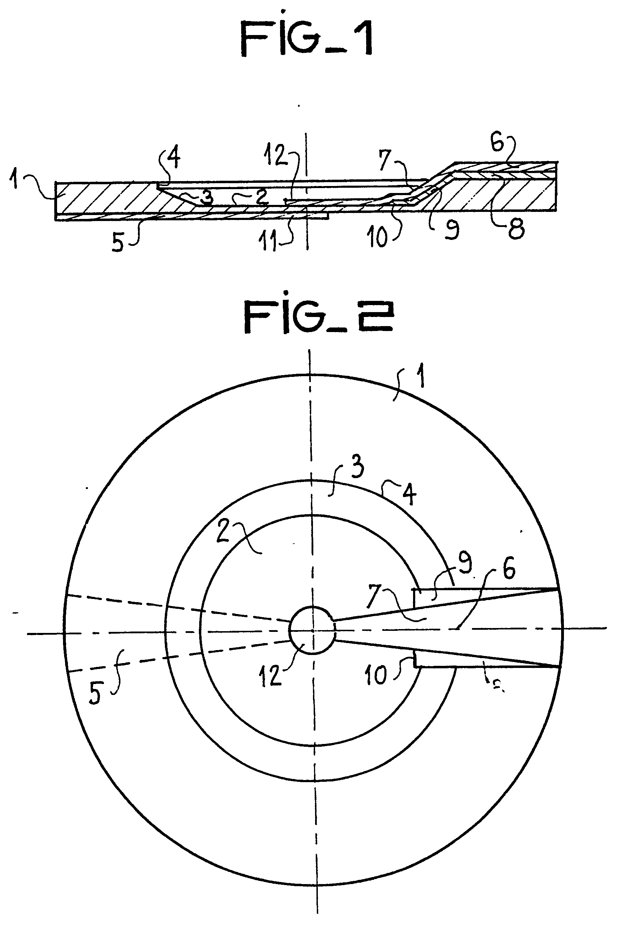

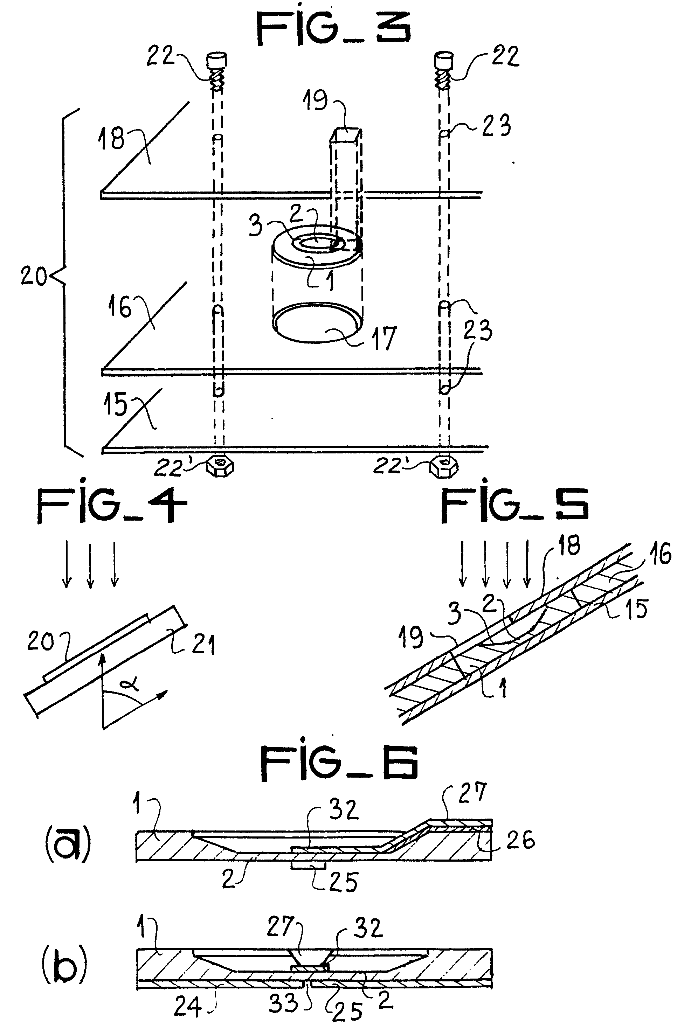

Selon les figures 1 et 2, un disque piézo-électrique comporte une région périphérique non amincie 1, entourant une région amincie 2, le raccordement entre ces deux régions étant constitué par une zone formant gradin. Par usinage ionique, voir par exemple L'ONDE ELECTRIQUE, vol. 50, n° 11, novembre 1979, pages 75–80, on obtient un gradin constitué à partir de la surface par une région cylindrique 4 suivie d'une région conique 3. Par exemple, pour un disque d'épaisseur 50 microns et une épaisseur de la membrane 2 de l'ordre de 5 à 10 microns, la région cylindrique 4 a une profondeur d'environ 10 microns. Une des électrodes 5 est disposée à la partie inférieure plane du disque et s'étend depuis la périphérie de celui-ci jusqu'au centre de la membrane 2 où elle se termine par une région circulaire 11. L'électrode 5 a une forme générale triangulaire dont la base est située à la périphérie du disque et le sommet du côté de la membrane 2. Cette forme permet d'assurer facilement le raccordement électrique des électrodes à leur périphérie, tout en apportant le moins de matière possible au niveau de la membrane 2.

L'autre électrode s'étend également depuis la périphérie du disque jusqu'au centre de la membrane 2 où elle se termine par une région circulaire 12 en regard de la région circulaire 11. De la même façon, cette électrode présente une forme générale triangulaire dont la base est située du côté de la périphérie du disque. Une patte conductrice 8 est disposée de préférence sous l'électrode 6 et s'étend depuis la périphérie du disque jusqu'à la partie externe de la membrane 2 jouxtant la zone 3 formant gradin. Cette patte conductrice 8 est une couche métallique déposée sur le disque et qui en vue de dessus présente une forme rectangulaire. Dans cette réalisation, la patte 8 est donc plus large que l'électrode, ce qui augmente la surface où un contact électrique est réalisé au niveau de la zone formant gradin. D'autre part, la patte conductrice s'étend au niveau de la membrane d'une longueur juste suffisante pour permettre de faciliter le raccordement électrique au niveau du gradin. On notera que la zone active de la patte conductrice est celle située au niveau du gradin, à savoir la zone représentée en 9, son prolongement en 10 d'une distance minimale sur la membrane 2, et son raccordement avec la partie plate de l'életrode 6.

Sur la figure 3, un dispositif de masquage 20 destiné à la réalisation des pattes conductrices comporte une plaque de base 15, une plaque intermédiaire 16 pourvue d'une pluralité de trous 17 (dont un seul est représenté), et une plaque supérieure 18 pourvue d'ouvertures 19 (dont une seule est représentée) correspondant à la forme des pattes conductrices à réaliser sur un disque piézo-électrique pourvu d'une membrane 2. Les trous 17 ont un diamètre extérieur correspondant au diamètre des disques piézo-électriques. La plaque intermédiaire 16 a une épaisseur légèrement supérieure à celle des disques piézo-électriques, de telle sorte que les disques sont maintenus en position par serrage entre les plaques 15 et 18. Les plaques 15, 16 et 18 sont maintenues entre elles par des vis de serrage 22 engagées dans des trous 23, et coopérant avec des écrous 22'.

Selon la figure 4, le support 20 comportant les disques piézo-électriques est monté sur une platine 21 inclinée d'un angle α par rapport à la direction de pulvérisation ou d'évaporation.

Comme le montre le détail de la figure 5, cette inclinaison permet de disposer la portion de région 3 où est réalisée la patte conductrice sensiblement perpendiculaire à la direction de pulvérisation. Ceci permet d'obtenir par évaporation une épaisseur maximale pour la patte conductrice dans sa zone active. La patte conductrice 8 peut être en tout métal qui peut être déposé par pulvérisation ou évaporation et notamment en or. Son épaisseur, par exemple de l'ordre de 0,1 μm (1000 Angstroems), est telle qu'elle permet de renforcer l'électrode 6 sans apporter trop de matière au niveau du gradin.

Chaque disque piézo-électrique muni de sa patte conductrice est soudé sur deux mâts conducteurs à l'aide d'un ciment conducteur. Les électrodes 5, 6 sont ensuite déposées, chacune des électrodes se trouvant en contact avec un des mâts. L'électrode qui franchit le gradin recouvre au moins partiellement la patte conductrice.

Pendant le dépôt des électrodes, on mesure la fréquence du résonateur dès que l'épaisseur des électrodes le permet. L'apport de matière produit au niveau de la membrane par le dépôt des électrodes fait baisser la fréquence du quartz. Le dépôt est interrompu lorsque la fréquence désirée du quartz est précisément atteinte.

La quartz une fois mis sous boîtier étanche sous vide est soumis à un vieillissement (séjour de quelques heures à une température de l'ordre de 95 °C).

Selon les figures 6a et 6b, un filtre piézo-électrique est obtenu au niveau d'une membrane 2 par couplage entre deux résonateurs individuels. Pour ce faire, deux électrodes rapprochées sont disposées sur une des faces de la membrane, et une électrode de masse est disposée sur la face opposée de manière que son extrémité soit située en face de l'intervalle entre les deux électrodes de l'autre face. Ainsi, une électrode 27 est disposée sur la face supérieure d'un disque de quartz et s'étend depuis la périphérie de celui-ci jusqu'au centre de la membrane 2 où elle présente une terminaison circulaire 32. Deux électrodes 24 et 25 de direction générale perpendiculaire à l'électrode 27 s'étendent depuis la périphérie de la face inférieure du disque piézo-électrique jusqu'au centre de la membrane 2 où elles sont séparées l'une de l'autre par un intervalle 33 dont la largeur détermine le couplage entre les deux résonateurs.

**Revendications**

1. Résonateur piézo-électrique à haute fréquence, du type comprenant une plaque ou un disque en matériau piézo-électrique dont une région non amincie entoure une région amincie formant une membrane, la région amincie étant raccordée à la région non amincie par au moins une zone formant gradin, et comportant au moins une électrode s'étendant, en franchissant le gradin, depuis la région non amincie jusqu'à la région amincie, caractérisé en ce que ladite électrode est associée à une patte conductrice (8) constituée par une couche métallique (9) déposée dans la zone formant gradin.

2. Résonateur selon la revendication 1, caractérisé en ce que ladite couche métallique (9) est une couche déposée par pulvérisation ou évaporation.

3. Résonateur selon la revendication 2, caractérisé en ce que ladite patte (8) est disposée en-dessous de l'électrode (6).

4. Résonateur selon l'une des revendications 2 ou 3, caractérisé en ce que la patte (8) est en or.

5. Résonateur selon l'une des revendications précédentes, caractérisé en ce que la patte (8) a une épaisseur moyenne de l'ordre de 1000 Angstroems.

6. Résonateur selon l'une des revendications précédentes, caractérisé en ce qu'une électrode (5, 6) est en aluminium.

7. Résonateur selon l'une des revendications précédentes, caractérisé en ce qu'une électrode (5, 6) a une épaisseur comprise entre 0,05–0,1 µm (500 et 1000 Angstroems).

8. Résonateur selon l'une des revendications précédentes, caractérisé en ce que la patte conductrice (8) est plus large que l'électrode (6).

9. Résonateur selon l'une des revendications précédentes, caractérisé en ce que la patte conductrice (8) s'étend depuis la région non amincie jusqu'à la partie externe (10) de la région amincie jouxtant la zone (3) formant gradin.

10. Résonateur selon l'une des revendications précédentes, caractérisé en ce qu'il comporte deux résonateurs élémentaires couplés entre eux de manière à former un filtre.

11. Procédé de fabrication d'un résonateur selon l'une des revendications précédentes comportant une étape préliminaire de réalisation par usinage ionique d'une région amincie dans la partie centrale d'une plaque ou d'un disque de quartz, la région amincie étant séparée d'une région non amincie par une zone formant gradin, caractérisé en ce qu'il comporte les étapes suivantes:

a) une étape de dépôt d'une patte conductrice (8) traversant la zone (3) formant gradin;

b) une étape de montage de la plaque ou du disque sur au moins deux mâts conducteurs à l'aide d'un ciment conducteur;

c) une étape de dépôt des électrodes (5, 6) dont une recouvre au moins partiellement la patte conductrice, la pulvérisation étant réalisée de telle sorte que chacun des mâts se trouve en contact avec une électrode.

12. Procédé selon la revendication 11, caractérisé en ce qu'il comporte une opération de mesure de la fréquence du résonateur pendant le dépôt des électrodes de manière à arrêter celui-ci lorsque la valeur désirée de la fréquence a été atteinte.

**Claims**

1. A high frequency piezoelectric resonator of the type comprising a plate or a disk of a piezoelectric material having a thinner region which constitutes a diaphragm and which is surrounded by a region which has not been rendered thin, the thinner region being coupled to the other region via at least one zone constituting a stepping, and comprising at least one electrode which extends from the region which has not been made thin through the stepping to the thinner region, characterized in that said electrode is associated to a conducting strip (8) constituted by a metal layer (9) which is deposited on the zone constituting the stepping.

2. A resonator according to claim 1, characterized in that said metal layer (9) is a layer which has been deposited by pulverisation or evaporation.

3. A resonator according to claim 2, characterized in that said strip (8) is disposed underneath the electrode (6).

4. A resonator according to one of claims 2 or 3, characterized in that the strip (8) is made of gold.

5. A resonator according to one of the preceding claims, characterized in that the strip (8) has a mean thickness of about 1000 Angstroem.

6. A resonator according to one of the preceding claims, characterized in that one electrode (5, 6) is made of aluminium.

7. A resonator according to one of the preceding claims, characterized in that the thickness of one electrode (5, 6) is included between 0,5 and 0,1 µm (500 and 1000 Angstroem).

8. A resonator according to one of the preceding claims, characterized in that the conducting strip (8) is larger than the electrode (6).

9. A resonator according to one of the preceding claims, characterized in that the conducting strip (8) extends from the region which has not been made thin to the outer portion (10) of the thinner region in the vicinity of the zone (3) constituting the stepping.

10. A resonator according to one of the preceding claims, characterized in that it comprises two elementary resonators which are mutually coupled such that they constitute a filter.

11. A method of manufacturing a resonator according to one of the preceding claims, comprising a preliminary step of realizing by ion treatment a thinner region is the central portion of a plate or disk of quartz, the thinner region being separated from a region which has not been made thin by a zone constituting a stepping, characterized in that it includes the following steps:

a) a step of depositing a conducting strip (9) which passes through the zone (3) constituting the stepping,

b) a step of mounting the plate or disk on at least two conducting masts by means of a conducting cement,

c) a step of depositing the electrodes (5, 6),one of which covers the conducting strip at least partially, the pulverization taking place in such a way that each one of the masts gets into contact with one electrode.

12. A method according to claim 11, characterized in that it comprises a step of measuring the frequency of the resonator during the electrode deposition step such that the latter is stopped as soon as the desired frequency value has been obtained.

**Patentansprüche**

1. Piezoelektrischer Hochfrequenzresonator mit einer Platte oder Scheibe aus piezoelektrischem Material, auf der ein dünngemachter Bereich, der eine Membran bildet, von einem nicht dünngemachten Bereich umgeben wird und an den nicht dünngemachten Bereich über mindestens eine eine Abstufung bildende Zone angeschlossen ist, und mit mindestens einer Elektrode, die von dem nicht dünngemachten Bereich bis zum dünngemachten Bereich über die Abstufung hinweg verläuft, dadurch gekennzeichnet, dass diese Elektrode einem Leiterstreifen (8) zugeordnet ist, der von einer in der die Abstufung bildenden Zone aufgebrachten Metallschicht (9) gebildet wird.

2. Resonator nach Anspruch 1, dadurch gekennzeichnet, dass die Metallschicht (9) eine Schicht ist, die durch Pulverbeschichtung oder Aufdampfung aufgebracht ist.

3. Resonator nach Anspruch 2, dadurch gekennzeichnet, dass der Streifen (8) unterhalb der Elektrode (6) verläuft.

4. Resonator nach einem der Ansprüche 2 oder 3, dadurch gekennzeichnet, dass der Streifen (8) aus Gold ist.

5. Resonator nach einem der vorhergehenden Ansprüche, dadurch gekennzeichnet, dass der Streifen (8) eine mittlere Dicke in der Grössenordnung von 1000 Angstroem besitzt.

6. Resonator nach einem der vorhergehenden Ansprüche, dadurch gekennzeichnet, dass eine Elektrode (5, 6) aus Aluminium ist.

7. Resonator nach einem der vorhergehenden Ansprüche, dadurch gekennzeichnet, dass eine Elektrode (5, 6) eine Dicke zwischen 0,05 und 0,1 µm (500 bis 1000 Angstroem) aufweist.

8. Resonator nach einem der vorhergehenden Ansprüche, dadurch gekennzeichnet, dass der leitende Streifen (8) breiter als die Elektrode (6) ist.

9. Resonator nach einem der vorhergehenden Ansprüche, dadurch gekennzeichnet, dass der leitende Streifen (8) sich von dem nicht dünngemachten Bereich bis zu einem Bereich (10) erstreckt, der am Rand des dünngemachten Bereichs in der Nähe der die Abstufung bildenden Zone (3) liegt.

10. Resonator nach einem der vorhergehenden Ansprüche, dadurch gekennzeichnet, dass er zwei Elementarresonatoren besitzt, die miteinander gekoppelt sind, so dass sie ein Filter bilden.

11. Verfahren zur Herstellung eines Resonators nach einem der vorhergehenden Ansprüche, bei dem zuerst durch Ionenbeschuss ein dünnerer Bereich in der zentralen Zone einer Platte oder Scheibe aus Quarz hergestellt wird, wobei der dünngemachte Bereich von einem nicht dünngemachten Bereich durch eine eine Abstufung bildende Zone getrennt ist, dadurch gekennzeichnet, dass das Verfahren folgende Schritte aufweist:

a) Aufbringen eines leitenden Streifens (9), der die die Abstufung bildende Zone (3) quert,

b) Montage der Platte oder Scheibe auf mindestens zwei leitenden Pfosten mithilfe eines leitenden Zements,

c) Aufbringen der Elektroden (5, 6), von denen die eine mindestens teilweise den leitenden Streifen bedeckt, wobei die Pulverbeschichtung so durchgeführt wird, dass jeder der Pfosten in Kontakt mit einer Elektrode steht.

12. Verfahren nach Anspruch 11, dadurch gekennzeichnet, dass es einen Verfahrensschritt enthält, bei dem die Frequenz des Resonators während des Aufbringens der Elektroden gemessen wird, so dass letzteres beendet wird, wenn der gewünschte Frequenzwert erreicht ist.

# FIG_1

# FIG_2

0 096 611

# FIG_3

# FIG_4

# FIG_5

# FIG_6

(a)

(b)